# EUROPEAN PATENT SPECIFICATION

(11) **EP 2 789 027 B1**
(45) Date of publication and mention of the grant of the patent: **14.08.2019**
(21) Application number: 12795480.8
(22) Date of filing: 06.12.2012
(51) Int. Cl.: H01L 51/44

(54) **ORGANIC PHOTOVOLTAIC DEVICE**
ORGANISCHES PV-MODUL
DISPOSITIF PHOTOVOLTAÏQUE ORGANIQUE

(30) Priority: 06.12.2011 EP 11192235; 14.12.2011 EP 11193453
(43) Date of publication of application: 15.10.2014
(73) Proprietor: Novaled GmbH, 01099 Dresden (DE)
(72) Inventor: MURANO, Sven, 01309 Dresden (DE); BIRNSTOCK, Jan, 01187 Dresden (DE); RUNGE, Steffen, 04109 Leipzig (DE); WERNER, Ansgar, 01277 Dresden (DE); HOFMANN, Michael, 01744 Dippoldiswalde OT Reinholdshain (DE); CANZLER, Tobias, 01099 Dresden (DE); LESSMANN, Rudolf, 40591 Düsseldorf (DE)
(74) Representative: Bittner, Thomas L.
(86) International application number: PCT/EP2012/074679
(87) International publication number: WO 2013/083713

(56) References cited:
- WO-A1-2008/009428
- WO-A1-2011/098544
- WO-A2-2010/110567
- CN-A- 101 740 649
- JP-A- 2011 114 004
- US-A1- 2008 116 536
- US-A1- 2010 319 765
- US-A1- 2010 326 499
- US-A1- 2011 226 322

## Description

The present disclosure refers to technologies in the field of organic photovoltaic devices.

### Background

Organic semiconductor devices are made by layers; such organic semiconducting layers mainly comprise conjugated organic compounds, which can be small molecules, for instance monomers, or oligomers, polymers, copolymers, copolymers of conjugated and non-conjugated blocks, completely or partially cross-linked layers, aggregate structures, or brush like structures. A device made with different types of compounds, in different layers or mixed together, for example with polymer and small molecule layers, is also called a polymer - small molecule hybrid device. Organic photovoltaic devices (OPVD), also known as organic solar cells, are preferentially made of small molecules because the deposition techniques involved in fabricating small molecule OPV devices enable the fabrication of multilayer structures.

Since 1987, large efforts were undertaken worldwide by research groups and by industrial organizations to improve the performance of OPVDs, especially of small molecule OPVDs. One of the first quests was to find suitable organic semiconductor materials made of small molecules which are able to form homogeneous layers. Nowadays, charge carrier transporting materials for industrial use are morphologically stable at least to the temperature of 85 °C, typical materials have glass transition temperatures above 100 °C. At the same time, the charge carrier transporting materials need to fulfill a set of other requirements, such as high transparency in the visible spectrum and good charge transporting abilities.

Most of the good performance electron or hole transport materials are relatively high cost materials mainly due to their complex synthetic route, which presents a problem to be solved.

Another problem to be solved is the enhancement of the light incoupling efficiency of OPVDs, including angle dependency. Typical organic OPVDs have the disadvantage that normal incident light which is not absorbed is outcoupled again and does not contribute to the photocurrent. Light on a high angle to the normal is reflected at the air-substrate or substrate bottom electrode / organic interface and also does not contribute to the photocurrent, characterizing a 'bad' angle dependency.

Several different techniques have been proposed for improving the overall light absorption by increasing the effective area of the solar cell, or by changing the angle of the air-substrate interface, etc. Such techniques have proven to be of complex fabrication and sometimes also ineffective.

For the use of OPVDs it is therefore necessary to use suitable light harvesting methods which could be incorporated inexpensively in the fabrication process. It is assumed that a OPVD has to cost less than 1 US$ per watt peak to be economically reasonable at the current top power conversion efficiencies of about 9 to 10 %. This means, however, that only particularly inexpensive methods come into consideration at all for increasing the light harvesting. OPVDs based on so-called small molecules (SM) are nowadays processed with, i.a., the aid of thermal evaporation in vacuum. Typically, OPVDs consist of two to twenty layers which are all individually thermally vapour-deposited. If the light harvesting can now be significantly improved by means of just one more single thermally vapour-deposited layer, the condition on the costs of the light harvesting method will be satisfied in any case. The same applies to SM-polymer hybrid OPVDs.

Document WO 2011/098544 A1 discloses a layer system for producing a solar cell comprising a metal substrate provided with an embossed polymer coating layer, a solar cell back electrode following the shape of the embossed polymer coating layer, a photovoltaic active layer, and a transparent top electrode.

Document US 2010/0319765 A1 discloses a photovoltaic device including a photoactive layer which has at least one embossed pattern on a surface thereof.

Document WO 2010110567 A2 discloses a solar cell comprising a first electrode formed on a substrate, a photoactive layer formed on the first electrode, and a second electrode formed on the photoactive layer. Nano-crystals are distributed in the photoactive layer.

Document US 2010/0326499 A1 discloses a solar cell including a substrate and an electron conductor layer, wherein the electron conductor layer form a pattern of projections with one or more gaps between the projections.

Document WO 2008/009428 A1 discloses a polymer based solar cell. The solar cell has a surface profile which enlarges the surface in relation to a smooth surface profile.

Document US 2008 / 0 116 536 A1 discloses a photosensitive optoelectronic device. The device comprises a substrate, an anode, a smoothing layer, a donor layer, several discontinuous layers, an acceptor layer, a blocking layer and a cathode.

Document JP 2001 114004 A discloses an organic solar cell with a positive electrode formed on a substrate, a hole transport layer, a photoelectric conversion layer, an electron transport layer, an electron transport layer and a negative electrode. The electrode transport layer has an uneven surface to form an irregular interface with the negative electrode.

### Summary

It is an object of the invention to provide improved technologies for an organic photovoltaic device with improved light harvesting efficiency, while maintaining a simple device structure and a simple manufacturing method.

According to an aspect, an organic photovoltaic device as in the independent claim 1 is provided. Also, according to the independent claim 13 a method of producing a photovoltaic device is provided.

In the present invention, there is a non-flat layer provided in the electronically active region provided between the bottom electrode and the top electrode. Also, there may be an electronically inactive non-flat layer provided between the substrate and the bottom electrode.

The non-flat layer may be electronically active. For example, the non-flat layer may be made of an electron and / or hole transporting semiconducting material.

At least one of the non-flat layer and the electrically inactive non-flat layer may be an organic layer made of one or more organic materials.

The non-flat layer is a non-closed layer comprising a plurality of particles (roughening structures providing non-flatness) provided on an underlying layer and separated from each other. The non-flat layer(s) may also referred to as roughening layer(s). The term "non-closed" as used here refers to a layer made of particles / roughening structures protruding from the underlying layer and separated from each other by spaces free of such structures. It may be that in the spaces free of the roughening particles / structures there is a flat, very thin ground layer with a layer thickness of less than 5 nm. Such ground or basis layer, e.g., may be due one or more molecular monolayers deposited in the process of the production of the non-flat layer(s).

In an embodiment, the plurality of particles may be provided in the ground layer, e.g. a monolayer of the material of which the non-flat layer is made. Such layer structure may be referred to as iceberg structure. The particles may be crystalline particles provided by a self- assembling (self-crystallizing) process after the layer material was deposited on the underlying layer, e.g. by vacuum deposition.

The particles may have a dimension of the wavelength of the light to be absorbed in the light absorbing region. The particles may be provided with a particle height about 3 to about 50 nm, preferably of about 3 to about 15 nm, and a lateral dimension of 50 to 2000 nm, the height being perpendicular to a direction parallel to the surface of the substrate.

The bottom electrode may be a non-flat electrode, a non-flat surface structure of the non-flat electrode being caused by the non-flat or roughening structure(s) of the electrically inactive non-flat layer. The non-flat layer and / or the electrically inactive non-flat layer may be referred to as an electrode structure forming or an electrode structuring layer. The non-flat structure of the non-flat layer provides for an electrode structure, at on the electrode surface proximal to the electronically active region, with a light scattering surface scattering light out of the direction of the surface normal.

The non-flat layer causes the top electrode to be provided with an electrode roughness by roughening the top electrode on an outer side of the top electrode facing away from the electronically active region. The top electrode roughness may comprise roughened / non-flat inner surface structures on the inner side of the top electrode which is facing the electrically active region. Looking from above on the electrode, the roughened inner surface structures and the roughened outer surface structures may essentially overlap. Similarly, the bottom electrode may be provided with roughened / non-flat outer surface structures caused by the electronically inactive non-flat layer.

The electronically active non-flat layer may be provided between the top electrode and the light absorbing region, or the bottom electrode and the light absorbing region.

The top electrode may comprise a metal layer. Due to the non-flat structure of the non-flat layer the metal layer is provided with a non-flat structure. The metal layer may provide a light reflecting surface on the inner side of the electrode. The electronically active region may comprise an additional light absorbing region separated from the light absorbing region by in intermediate region, the additional light absorbing region being provided between the non-flat layer and the top electrode.

The height of the particles is bigger than a distance between a side of the top electrode proximal to the electronically active region and a first optical maximum of the optical field. An optical maximum occurs due to multiple reflections and constructive interference between the optically thick and semitransparent metal layers enclosing the organic layers in a microcavity structure. Depending on the width of the cavity, several optical maxima might occur. Numbering starts from the optical maximum which is closest to the highly reflective electrode. For an optimized device where the upper most absorbing layer is in the first optical maximum, the distance referred above is the distance between the top electrode and the middle of the upper most absorbing layer. This is the distance necessary for the optical cavity in an optimized device, in this case, the height of the particles assures that the top electrode will not have a flat surface.

The non-flat layer is provided on an underlying layer which may contain fullerene or a compound comprising a fullerene. The fullerene may be C₆₀ or C₇₀. There may be direct contact between the non-flat layer and the layer comprising fullerene and / or a fullerene-based compound. The underlying layer may be made exclusively of fullerene or a fullerene-comprising compound.

At least one of the non-flat layer and the electrically inactive non-flat layer may be provided with a nominal layer thickness of 5 nm to 15 nm. A preferred nominal layer thickness is 6 to 10 nm, enabling devices with highest efficiencies.

At least one of the non-flat layer and the electrically inactive non-flat layer may comprise a compound according to the following formula (I): 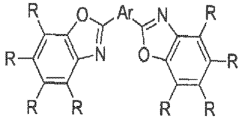 wherein Ar is C₆-C₂₀ aryl and each R is independently selected from H, C₁-C₂₀ alkyl, preferably C₁-C₁₀ alkyl, more preferably C₁-C₅ alkyl, C₆-C₂₀ aryl, preferably C₆-C₁₂ aryl, C₅-C₂₀ heteroaryl, preferably C₅-C₁₂ heteroaryl, halogen, nitro, CN and amine.

With respect to the method, the non-flat layer may be deposited by vacuum thermal evaporation. During the process of vacuum deposition a nominal thickness of the non-flat layer may be controlled by a quartz crystal monitor.

The non-flat layer may be directly deposited on a first organic semiconducting layer, and the material of the first organic semiconducting layer and the material of the non-flat layer may be selected to favor a Volmer-Weber growth mode.

Following, further aspects of the technologies disclosed are described.

The non-flat layer is a layer of a certain nominal thickness. It is named as a layer due to its deposition process in which layers are deposited on a layer-by-layer sequence. The non-flat layer is a region with particle like structures with a height-to-width ratio. The particles are spaced from each other and do not form a closed layer. The material which is subsequently deposited over the particles and which may fill the space between the particles may define another layer, for practical reasons. It may be referred to as the subsequent layer. The non-flat layer may also be referred to as "particles layer". The non-flat may provide a light scattering functionality. Therefore, in this case it may also be referred to as "scattering layer". It may serve as a template.

The particles may have a lateral dimension of 50 to 500 nm and a height of about 3 to about 50 nm, preferably of about 3 to about 15 nm. The particle density inside the organic photovoltaic device (OPV device) should be between 5 to 200 particles per µm², preferably between 10 to 50 particles per µm². The particles may have a dimension of up to 1000 nm. Those dimensions may provide for Mie scattering, that occurs preferentially on objects which have a diameter on the order of the wavelength of the visible light (between 450 and 700 nm), divided by the refractive index of the surrounding organic material.

The non-flat layer is grown in a Volmer-Weber (VW) or a Stranski-Krastanow (SK) mode. The VW mode is preferred. It is preferred that the particles have a random distribution and most of the surface of the underlying layer is uncovered by the material of the particle.

This invention enables an easy fabrication of the non-flat layer in a self assembled way. The material for the non-flat layer is an organic compound which preferentially deposited by conventional methods such as VTE, organic vapour phase deposition, or other method which is used for organic semiconductors. VTE is preferred.

Examples of materials for the non-flat layer are anthracene, phenanthrene, oxadiazole.

Preferred materials are very high gap materials, with an HOMO-LUMO gap larger than 3 eV, which further preferred do not play any electronically role in the device, i.e., neither electrons nor holes can be injected. In that case, the VW mode of deposition is a highly preferred.

The material of the non-flat layer may be an electron transport material (ETM). The ETM can be employed in a position in the device where electron transport is required.

The non-flat layer maybe provided between the absorbing layer and the top electrode. Preferably, a transport and / or injection layer is produced between the non-flat layer and the top electrode. In one optional embodiment, this adjacent upper layer has a thickness thinner than the height of the particles.

If the organic photoactive device is a tandem or multiple absorbing units stacked device, then the non-flat layer may be provided between the upper most absorbing layer and the top electrode. The upper most absorbing layer is the absorbing layer closest to the top electrode.

The organic photoactive device may be provided with doped charge transport layer(s) to ensure good charge extraction and injection at various interfaces and allow for thick charge transport layers with very low ohmic losses. The doped layers are mainly charge transport layers for electrons and holes. Since the non-flat layer(s) grown in VW mode may be provided as an undoped layer, the layer underneath and upper layer (the overcoat layer on top) enable good charge extraction for this non-flat layer.

The non-flat layer may be provided under a metallic top electrode for instance, between the bottom and the top metallic electrode. "Under" means it is closer spaced to the substrate than to the metallic electrode. The non-flat layer may be provided at a distance less than 50 nm from the upper metallic electrode. "Upper" means that the metallic electrode is farther spaced away from the substrate than the non-flat layer.

The top electrode may be the cathode of the device, in which case it the particles of the non-flat layer may consist of an ETM. Surprisingly good results were found for organic photoactive devices having the top electrode provided as a metal layer, preferably comprising A1 or Ag, even more preferably being the cathode.

The non-flat layer may be deposited directly on top of a layer comprising fullerene. Preferentially the layer comprising fullerene comprises only non-substituted fullerenes, such as C₆₀ and C₇₀.

In the case where the non-flat layer also forms a hole transport layer (HTL) (between anode and absorbing layer), materials from the class of benzanelated oxathiines (and higher homologues thereof), in particular 5,12-dioxa-7,14-dithia-pentacene, 2,2'-(perfluorocyclohexa-2,5-diene-1,4-diylidene)dimalononitrile, and 1,4-bis(benzo[d]oxazol-2-yl)naphthalene may be used for the non-flat layer(s).

In another embodiment the benzanelated oxathiines are excluded. In an embodiment, the following compounds shall be excluded:

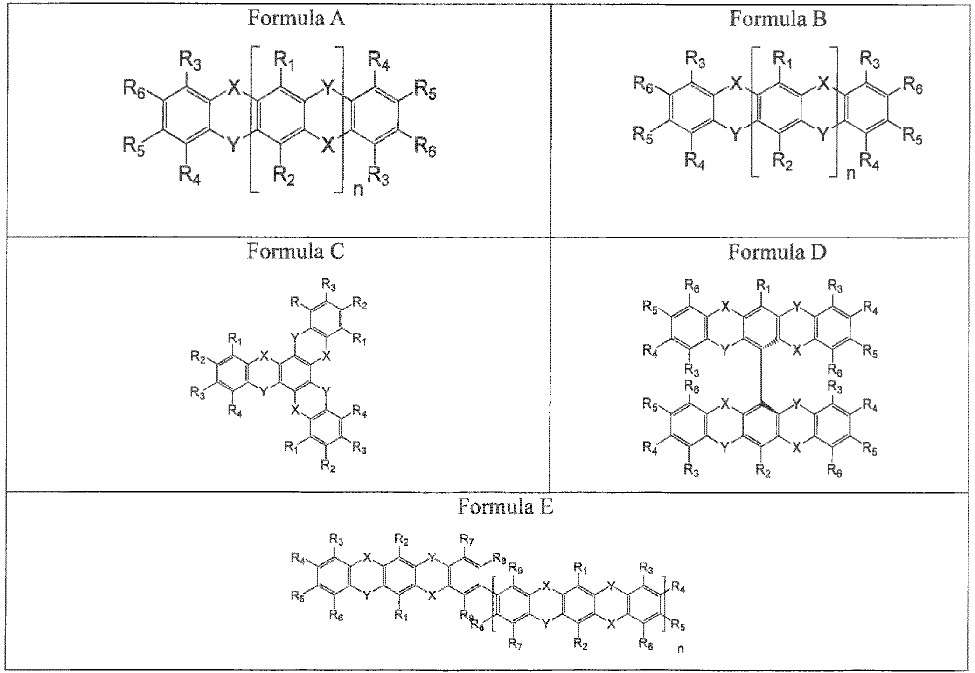

wherein X and Y are different from each other, but are otherwise independently selected from oxygen, sulphur, selenium and tellurium; n is 1, 2, 3, 4, 5 or 6; and R₁₋₉ are independently selected from hydrogen, alkyl, aryl, heteroaryl, fused carbocycle, fused heterocycle, OR', SR' and NR₂', wherein R' is independently selected from alkyl, aryl, heteroaryl, fused carbocycle and fused heterocycle.

By searching for an optimal, low cost transport material ETM, it was found that the compounds according to formula (I) have very specific thermal properties. The materials have no measurable glass transition temperature (Tg) and form very rough, crystallized layers. By doing OPVD experiments it was surprisingly found that the OPVD have a very good performance. Further analysis has shown that the fact that the compounds according to formula (I) form very rough layers does increase the performance of the OPVDs, instead of deteriorating the performance and damaging the device. This is in strong contradiction to the conventional belief that the materials must have a high Tg.

The organic photoactive device may comprise one or more layer made of a compound provided with at least one of the following features:
- There is a glass transition temperature at least 300 K below the melting temperature. Preferably the material does not present any measurable glass transition temperature at temperatures above room temperature and changes from the glassy state direct to the crystalline state or is not known in a glassy state at all.
- There is a high transparency also defined as a low extinction coefficient (smaller than 0.1) for all visible light.
- There is no apparent color.
- There is a HOMO-LUMO gap of at least 3 eV.
- The material is transparent in the visible region (optical gap > 3 eV).
- There is a LUMO smaller than 3.0 eV (in absolute values), which is atypical for ETMs used in OPVD, or a HOMO greater than 5.5 eV (in absolute values) which is atypical for HTMs used in OVPD.
- The molecular mass is greater than 200 g/mol and smaller than 400 g/mol (< 200 g/mol are compounds with too high volatility and > 400 g/mol are compounds which usually crystallize slowly).
- The compound comprises three aromatic units which are not condensed to each other, enabling independent rotation of any of the 3 units.

The thickness of the non-flat layer may be determined as a nominal thickness. Such nominal thickness is usually calculated from the mass deposited on a certain area by the knowledge of the material's density. For example, with vacuum thermal evaporation (VTE), the nominal thickness is the value indicated by the thickness monitor equipment. In reality, since the layer is preferentially not closed, it does not have a measurable thickness, only peaks (height of the particles).

Also, the nominal thickness of the roughening layer may be derived from AFM measurements.

The production process is adjusted to obtain the favorable growth mode: Deposition rate, substrate temperature during deposition, waiting time after film deposition (tempering). A low substrate temperature decreases the diffusion length so that the molecules are basically stuck in place and do not find their bulk arrangement. A higher substrate temperature gives the molecule the opportunity to diffuse on the surface to find a high coordination site and to cross activation barriers. A lowering of the deposition rate has a similar effect since the molecules have more time to diffuse to an existing crystallization nucleus promoting a low island density and higher order. In contrast, high deposition rates can even lead to amorphous film growth since the molecules are just stuck in place and have no time to rearrange.

Without being bound by theory, it is believed that the improvement of the organic photovoltaic device (OPVD) comes from several factors. The structuring of the electrode has different positive effects.

The structuring of the metal electrode using the non-flat layer as template leads to a backscattering of the incoming light with various scattering angles. Thus, the mean absorption path length in the absorber layer is increased and provides higher photo current.

Furthermore, the angular dependency can be improved using a non-planar structured electrode.

The top electrode, due to the non-flat layer(s), comprises a random roughness and, which roughness comprises features of a size, comprising at least one of the following:
- the size is such as to scatter light from and into the electronically active region, and/or
- the size is such as to avoid a plasmon resonance between the absorption layer of the electronically active region and the top electrode and/or
- the size is such to enhance the light harvesting from the plasmon modes.

In an organic solar cell the absorbing layer is preferentially a hetero-junction (HJ). Typical HJ are flat heterojunctions or bulk-heterojunctions. Flat heterojunctions comprise at least two layers, where the energy levels of the at least two layers form an energy interface to separate the charges of the excitons. Preferentially the at least two layers form a staggered type II heterojunction. Examples of flat heterojunctions are ZnPc/C₆₀ double layers. In the flat heterojunctions at least one of the layers comprises an absorbing material. The materials which are not absorbing must be good charge transporting materials. The absorbing materials are optionally good transporting materials, especially if the layers are thicker than 5 nm. Bulk heterojunctions comprise normally one layer in which at least two materials are mixed, the energy levels of the at least two layer form an energy interface to separate the excitons. Graded or other layers are also possible, for example a HJ can be formed by a mixture between flat and bulk heterojunction as in Xue et al. Adv. Mat., V. 17, pp. 66-71, 2004.

The photoactive layer in a solar cell is defined as the layer in combination with a HJ which is responsible for the generation of excitons due to absorption of photons. This layer usually comprises a material which has an extinction coefficient > 1.10⁴ M⁻¹cm⁻¹ over a range of wavelengths of at least 100 nm which includes its absorption peak, where the peak is located in the range of 400 nm to 1200 nm.

The OPVD may comprise electron transport layer(s) and hole transport layer(s).

Reliable and at the same time efficient OPVDs are those comprising electrically doped transport layers. By electrically doping hole transport layers with a suitable acceptor material (p-doping) or electron transport layers with a donor material (n-doping), respectively, the density of charge carriers in organic solids (and therefore the conductivity) is increased substantially. Additionally, analogous to the experience with inorganic semiconductors, some applications can be anticipated which are precisely based on the use of p- and n-doped layers in a component and otherwise would not be conceivable. The use of doped charge carrier transport layers (p-doping of the hole transport layer by admixture of acceptor-like molecules, n-doping of the electron transport layer by admixture of donor-like molecules) in OPVDs is, e.g., described in US 7,675,057 B2.

Electrical doping of organic semiconducting layers may be used in the organic photoactive device. This electrical doping of one or more organic layers in the electronically active region of the device can also be called redox-doping or charge transfer doping. It is known that the doping increases the density of charge carriers of a semiconducting matrix towards the charge carrier density of the undoped matrix.

Typical examples of doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; a-NPD (N,N'-Bis(naphthalen-1-yl)-N,N'-bis(phenyl)-benzidine) doped with F4TCNQ. a-NPD doped with 2,2'-(perfluoronaphthalene-2,6-diylidene) dimalononitrile (PD1). a-NPD doped with 2,2',2"-(cyclopropane-1,2,3-triylidene)tris(2-(p-cyanotetrafluorophenyl)acetonitrile) (PD2). N4,N4,N4",N4"-tetra([1,1'-biphenyl]-4-yl)-[1,1':4',1"-terphenyl]-4,4"-diamine (HTM1) doped with PD2.

Typical examples of doped electron transport materials are: fullerene C₆₀ doped with acridine orange base (AOB); perylene-3,4,9,10-tetracarboxylic-3,4,9,10-dianhydride (PTCDA) doped with leuco crystal violet; 2,9 - di (phenanthren-9-yl) - 4,7 - diphenyl - 1,10 - phenanthroline doped with tetrakis (1,3,4,6,7,8 - hexahydro - 2H - pyrimido[1,2-a]pyrimidinato) ditungsten (II) (W₂(hpp)₄, ND1); naphthalene tetracarboxylic acid di-anhydride (NTCDA) doped with 3,6-bis-(dimethyl amino)-acridine; NTCDA doped with bis(ethylene-dithio) tetrathiafulvalene (BEDT-TTF). Other compounds useful as n-dopants specifically in fullerene electron-transporting materials are phosphinimine compounds represented by Nl,N4-bis(tri-p-tolylphosphoranylidene)benzene-1,4-diamine (ND2).

All the organic layers in the arrangement of stacked layers may be fabricated by means of evaporation in vacuum (VTE - vacuum thermal evaporation). Alternatively, the organic layers in the arrangement of stacked layers can be fabricated by means of organic vapour phase deposition. In a preferred embodiment all the organic layers and both electrodes are deposited in a vacuum coating process, for example, VTE or sputtering.

The non-flat layer may be formed as vapour-deposited layer from an organic material which can be evaporated by means of thermal evaporation in vacuum. For this purpose the material has an evaporation (or sublimation) temperature in vacuum that is lower than the decomposition temperature in vacuum. Alternatively or additionally, the non-flat layer(s) can be fabricated by means of organic vapour phase deposition.

The non-flat layer may be made of an organic material which has a Tg below about 40°C. Preferably a material having no Tg is used. In this way, the organic material can crystallize during vapour deposition onto the substrate without any further tempering step since in conventional VTE systems the substrate temperature is usually between 20°C and 60°C. The Tg is determined by means of a DSC measurement. The DSC measurement is performed using a material which after fusing, is brought to room temperature by means of shock cooling. Thereafter the material is heated during the measurement at a rate of 10 K/min. In the preferred materials used in the non-flat layer, no Tg was observed.

The non-flat organic layer(s) may crystallize during the vapour deposition. Alternatively, a tempering step may follow after the completion of the layer and before the deposition of the next layer.

According to an embodiment, there is an organic photovoltaic device comprising a layered structure. The layered structure may comprise a substrate, a bottom electrode and a top electrode, wherein the bottom electrode is closer to the substrate than the top electrode, the region between the bottom electrode and the top electrode defining an electronically active region. The electronically active region may comprise a light absorbing region and at least one of a non-flat layer of an organic material and an electrically inactive non-flat layer is comprised between the substrate and the bottom electrode.

In the above disclosure and / or the following disclosure one or more of the following terms may be used.

ETL - electron transport layer, is a layer which is used in a device stack in such a way that the main charge carriers are electrons. Typically, this layer comprises an electron transport material (ETM). Hole blocking layers, exciton blocking layers between the cathode and its closest donor-acceptor heterojunction are also electron transport layers. Electron injection layers could also be electron transport layers, if they are semiconductors comprising an ETM.

ETM - electron transport material is a semiconducting material which is stable towards reduction and has a high mobility for electrons. In an ETM, the electron mobility is typically higher than the hole mobility.

HTL - hole transport layer is a layer which is used in a device stack in such a way that the main charge carriers are holes. Typically this layer comprises a hole transport material (HTM).

HTM - hole transport material is a semiconducting material which is stable towards oxidation and has a high mobility for holes. In a HTM, the hole mobility is typically higher than the electron mobility.

FHJ - Flat heterojunction is a donor-acceptor heterojunction in which the donor and acceptor materials are in separate layers. Preferentially the donor and acceptor materials are in adjacent layers providing a hetero-interface. Alternatively, other layers can be placed in between, to assist the light absorption and/or charge carrier separation.

BHJ - Bulk heterojunction is a mixed layer comprising a donor, an acceptor, and an absorbing material. Typically at least one of the donor and acceptor materials are also the absorbing material. The donor-acceptor heterointerface is necessary for the dissociation of the excitons, formed by photoabsorption, into mobile charges. A bulk heterojunction can be graded, or also comprise additional layers. A bulk donor-acceptor heterojunction can also be a hybrid junction, comprising a mixed layer and at least one layer comprising: the acceptor but no donor material, or the donor but no acceptor material. Such a heterojunction can also be a graded bulk heterojunction.

Acceptor - Acceptor, as used here, is a compound used in an optically active layer of a solar cell to assist the excitonic separation into charge carriers, accepting the electron. The term acceptor must not be confused with an electrical p-dopant which is a very strong acceptor capable of doping a hole transport layer.

Donor - Donor, as used here, is a compound used in an optically active layer of a solar cell to assist the excitonic separation into charge carriers, donating an electron (accepting a hole). The term donor must not be confused with an electrical n-dopant which is a very strong donor capable of doping an electron transport layer.

Electrical dopant - Electrical dopant is a dopant which is capable to, when added to a semiconductor, increase its charge carrier density, consequently increasing its conductivity. The increase in charge carrier density is due to a charge transfer between the LUMO and HOMO of the at least two components of the dopant-semiconductor system. The term electrically doped refers to a layer or material which is doped by an electrical dopant, as defined above.

n-dopant - electrical dopant capable of increasing the density of negative charge carriers in an electron transport material or electron transport layer. The negative charge carriers are provided on the effective conduction band of the electron transport layer (typically the LUMO of the electron transport material).

p-dopant - electrical dopant capable of increasing the density of positive charge carriers in a hole transport material or hole transport layer. The positive charge carriers are provided on the effective valence band of the hole transport layer (typically the HOMO of the hole transport material).

Transparency - those transport layers, which do not contribute to the photocurrent generation, are required to be transparent to avoid any efficiency loss due to undesired absorption. A high transparency is required in the range of wavelengths in which the solar cell is active. A high transparency preferentially means an extinction coefficient (k) smaller than 1, more preferably smaller than 0.1.

LUMO and HOMO refer to lowest unoccupied molecular orbital and highest occupied molecular orbital, respectively.

### Description of preferred embodiments

Following further embodiments will be described in further detail, by way of example, with reference to different embodiments. In the figures show:
- Fig. 1: a schematic representation of a layer sequence of organic photovoltaic device,
- Fig. 2: a schematic (cross section) representation of a layer structure with a roughening layer on an underlying layer,
- Fig. 3: a schematic (cross section) representation of a layer structure with a roughening layer on an underlying layer,
- Fig. 4: an underlying layer followed by a non-flat layer comprising particles and a transport layer deposited on top of the non-flat layer,
- Fig. 5: a schematic view of the cross-section of the organic photovoltaic device,
- Fig. 6: a schematic representation of a layer structure of an organic photoactive device,
- Fig. 7: a schematic representation of a layer structure of an organic photoactive device,
- Fig. 8: a schematic representation of a layer structure of an organic photoactive device,
- Fig. 9: a schematic representation of a layer structure of an organic photoactive device,
- Fig. 10A to 10C: experimental results determined by atomic force microscopy, and
- Fig. 11: a schematic representation for explaining characteristics of the organic photoactive device.

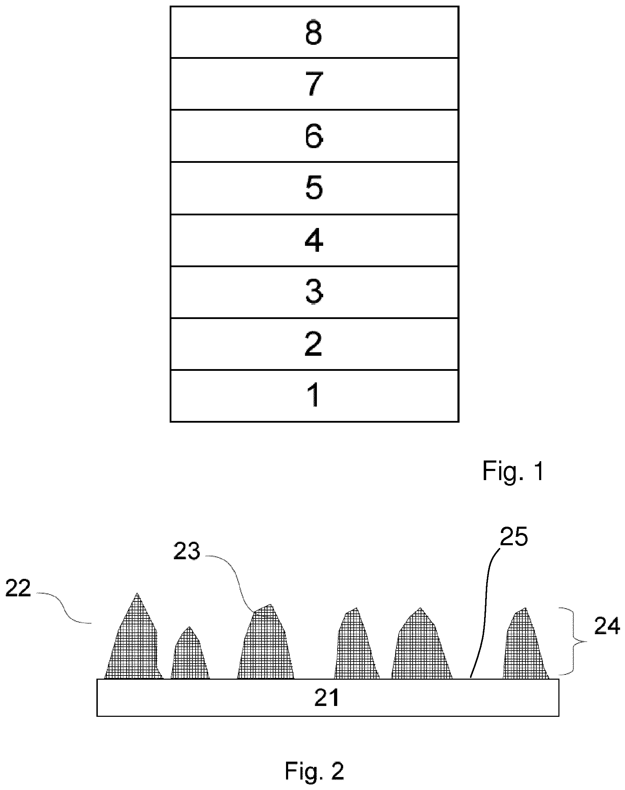

Fig. 1 shows a schematic representation of a layer sequence of organic photovoltaic device (OPVD). It starts with a substrate 1. A bottom electrode 2 is deposited over the substrate 1. Alight absorbing region is provided with light absorbing layers 3, 4, 5. The light absorbing region may comprise one or more light absorbing layers. A non-flat layer 6 is deposited between the bottom electrode 2 and a top electrode 8, in the embodiment shown, between the absorbing layer 5 and the top electrode 8. Optionally the stack has an additional charge carrier transport layer 7 between the non-flat layer 6 and the top electrode 8.

Fig. 2 shows a schematic (cross section) representation of a layer structure with a non-flat layer 22 on an underlying layer 21. The non-flat layer 22 is provided a non-closed layer. Particles 23 of the non-flat or roughening layer 22 are separated from each other providing an island or particle structure. The particles 23 have a height 24. There open spaces or regions 25 located between adjacent particles. In the open spaces 25 the material of the non-flat layer 22 does not cover the underlying layer 21. Such layer design, for example, may be generated by a Volmer-Weber (VW) mode growth of the non-flat 22 on the underlying layer 21.

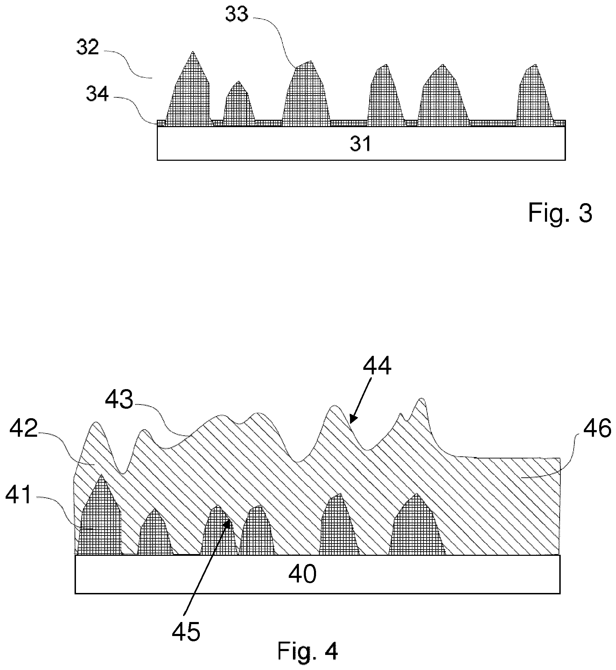

Fig. 3 shows a schematic (cross section) representation of a layer structure with a non-flat or roughening layer 32 provided with non-flat or roughening structures, namely particles 33, on an underlying layer 31. There is a ground layer 34 being made of the same material as the particles 33, having a thickness of 5nm or less and covering the underlying layer 31 in regions between the particles 33 providing the roughening structures. Together the particles 33 and the ground layer 34 provide an iceberg structure for the non-flat layer. Such layer structure, for example, may be provided by a Stranski-Krastanow (SK) mode growth of the non-flat layer 32 on the underlying layer 31.

Fig. 4 shows a schematic (cross section) representation of an underlying layer 40 followed by a non-flat layer 41, and a roughened layer 42 deposited on top of the non-flat layer 41. The roughened layer 42 is provided with a roughness comprising roughness structures 43 on the outer side 44 and the inner side 45. In other embodiments (not shown), the roughened layer 42 may be provided with surface roughness only on the inner side 45, while the outer side 44 is flat.

The layer 42 may be a transport layer optionally doped or an electrode.

Fig. 4 also shows a region 46 without roughening structures (without particles), such region can be created, e.g. by using shadow mask during evaporation. In the region 46, the thickness of the layer 42 can be directly measured, for instance by a profilometer. Note, the figures are only schematic and not necessarily in scale.

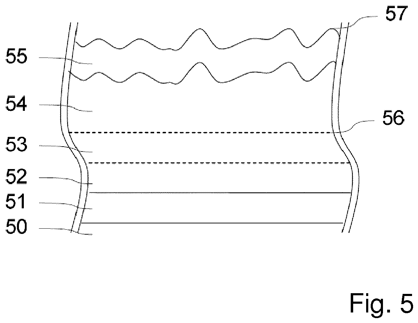

Fig. 5 shows a schematic representation of the cross-section of an organic photovoltaic device. On a substrate 50 a bottom electrode 51 is provided, for example an ITO anode. Organic layers 52, 53 and 54 are provided. An organic-organic interface is marked by a dashed line (e.g. 56). The organic layer 54 comprises also the non-planar layer (not explicitly shown), which leads to the corrugation 57 of the top electrode 55 provided, for example, as an A1 cathode.

The following compounds may be used for producing the non-flat layer(s) in the organic photoactive device:

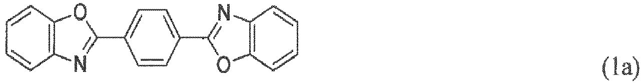

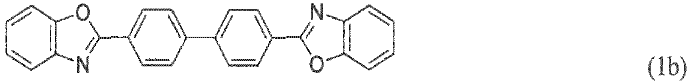

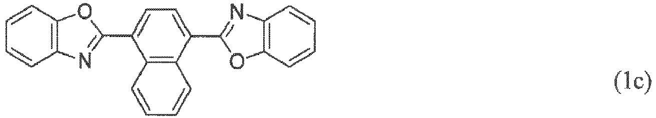

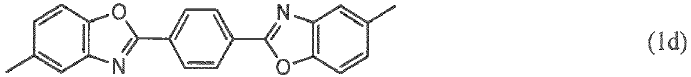

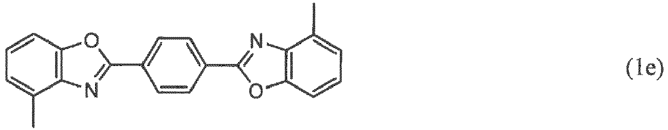

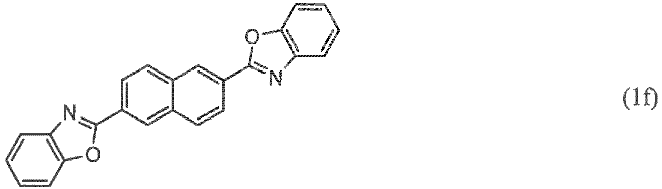

The compounds (1a) to (If) and their synthesis are known as such. One or more of the compounds have been used as fluorescent brighteners.

The synthesis of compounds 2,7,9-triphenyl-4-(p-tolyl)pyrido[3,2-h]quinazoline (ET1) and 4-(naphtalen-1-yl)-2,7,9-triphenylpyrido-[3,2-h]quinazoline (ET2) used in experimental devices as electron transporting materials was published in EP 1 970 371.

An organic photoactive device (solar cell) was prepared by using VTE.

The device was produced in a Lesker tool at a base pressure of 1E-7 mbar and room temperature. A patterned ITO layer of 90 nm on a glass substrate is used as bottom anode.

A thin PD2 layer of 2 nm is utilized for good charge extraction and injection, followed by a 5 wt % PD2 doped 40 nm HTM1 layer. 2 nm ET2 is deposited on top, to reduce exciton quenching at the dopants. This layer follows a 30 nm blend layer of C₆₀ and ZnPc with a volume mixing ratio of 1:1 and on top 30 nm pure C₆₀ layer. The non-flat layer consisting of compound (1a) is deposited, over the C₆₀ layer, with a nominal layer thickness of 0 to 14 nm and a deposition rate of 6 Å/s. A 10 nm 10 wt. % ND1 doped ET2 layer is deposited on the (1a) layer to ensure a good charge extraction to the 100 nm Ag top electrode deposited on top. No heating or cooling is used for the substrate during deposition. The results can be seen in Table 1. Best results were obtained with a non-flat layer between 6 nm and 10 nm.

**Table 1 shows the results determined for OPV devices by only varying the nominal non-flat layer thickness from 0 to 14 nm.**

| | non-flat layer | 0 nm | 6 nm | 8 nm | 10 nm | 14 nm |
|---|---|---|---|---|---|---|
| Voc | V | 0.55 | 0.55 | 0.55 | 0.55 | 0.55 |
| Jsc | mA/cm² | 10.0 | 10.3 | 11.0 | 10.7 | 10.6 |
| FF | % | 59 | 60 | 60 | 60 | 59 |
| Effi. | % | 3.2 | 3.4 | 3.6 | 3.5 | 3.4 |

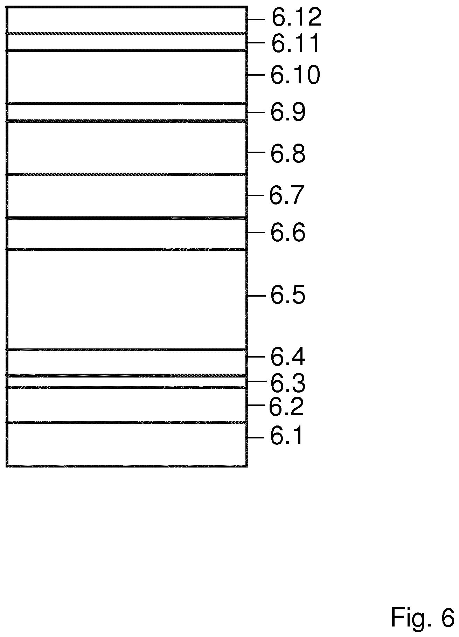

Fig. 6 shows a schematic representation of a layer structure of another organic photoactive device (SC2). The following layer structure is provided:
6.1: Glass substrate
6.2: ITO (layer thickness: 90 nm)
6.3: C₆₀ (5 nm)
6.4: (1a) (0-10 nm)
6.5: ET2:ND1 (10 weight % ND1) (80 nm)
6.6: ET2:ND1 (20 weight % ND1) (10 nm)
6.7: C₆₀ (20 nm)
6.8: C₆₀:ZnPc (weight ratio 1:1)
6.9: HTM1 (2 nm)
6.10: HTM1:PD2 (5 weight % PD2) (40 nm)
6.11: PD2 (2 nm)
6.12: Al (100 nm)

For comparison an organic photoactive device (SC1) was prepared without the non-flat layer 6.4.

**Table 2 provides results determined for the two devices.**

| | | SC1 | SC2 |
|---|---|---|---|
| non-flat layer | | no | yes |
| Voc | V | 0.56 | 0.56 |
| Jsc | mA/cm² | 9.3 | 9.7 |
| FF | % | 57 | 57 |
| Sat. | | 1.13 | 1.17 |
| Effi. | % | 3.0 | 3.1 |

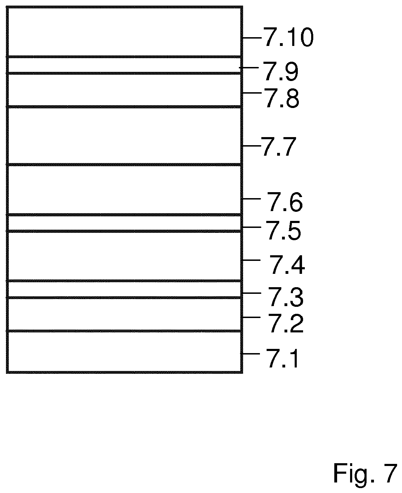

Fig. 7 shows a schematic representation of a layer structure of another organic photoactive device (SC4). The following layer structure was prepared:
7.1: Glass substrate
7.2: ITO (90 nm)
7.3: PD2 (2 nm)
7.4: HTM1:PD2 (5 wt. % PD2) (40 nm)
7.5: HTM1 (2 nm)
7.6: C₆ₒ:ZnPc (wt. ratio 1:1; 30 nm)
7.7: C₆₀ (20 nm)
7.8: (1a) (0-8 nm)
7.9: ET2:ND1 (10 wt. % ND1) (10 nm)
7.10: Ag (100 nm)

For comparison, an organic photoactive device (SC3) was prepared without the non-flat layer 7.8. Table 3 shows results determined for the two devices.

| | | SC3 | SC4 |
|---|---|---|---|
| non-flat layer | | no | yes |
| Voc | V | 0.56 | 0.56 |
| Jsc | mA/cm² | 10.5 | 11.5 |
| FF | % | 56 | 57 |
| Sat. | | 1.15 | 1.15 |
| Effi. | % | 3.3 | 3.7 |

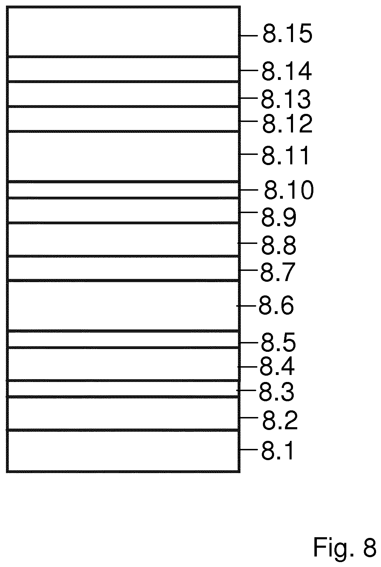

An other organic photoactive device (SC6) was prepared as shown in Fig. 8. The following layered structure was prepared:
8.1: Glass substrate
8.2: ITO (90 nm)
8.3: PD2 (2 nm)
8.4: HTM1:PD2 (5 wt % PD2) (40 nm)
8.5: HTM1 (2 nm)
8.6: C₆ₒ:ZnPc (wt ratio1:1; 30 nm)
8.7: C₆₀ (5 nm)
8.8: C₆₀:ND2 (20 wt %) (3 nm)
8.9: HTM1:PD2 (10 wt % PD2) (3 nm)
8.10: HTM1 (2 nm)
8.11: C₆₀:ZnPc (wt ratio 1:1; 30 nm)
8.12: C₆₀ (5 nm)
8.13: (1a) (0-10 nm)
8.14: ET2:ND1 (10 wt. % ND1) (10 nm)
8.15: Al (100 nm)

For comparison, an organic photoactive device (SC5) was prepared without the non-flat layer 8.13. Table 4 shows results determined for the two devices.

| | | SC5 | SC6 |
|---|---|---|---|
| non-flat layer | | no | yes |
| Voc | V | 1.06 | 1.06 |
| Jsc | mA/cm² | 6.7 | 7.2 |
| FF | % | 57 | 55 |
| Sat. | | 1.08 | 1.08 |
| Effi. | % | 4.0 | 4.2 |

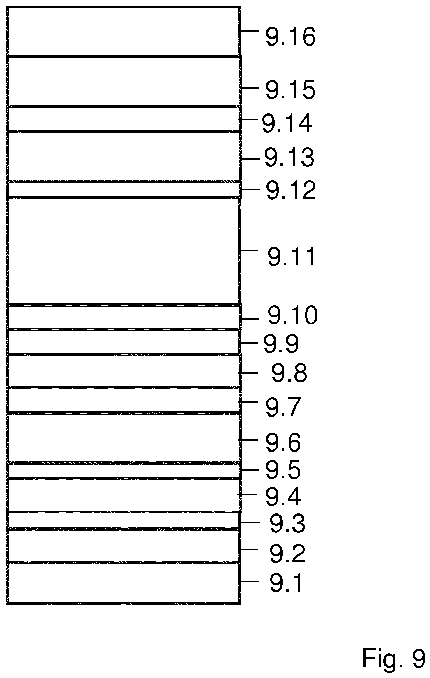

An other organic photoactive device (SC8) was prepared as shown in Fig. 9. The following layered structure was prepared:
9.1: Glass substrate
9.2: ITO (90 nm)
9.3: PD2 (2 nm)
9.4: HTM1:DP2 (5 wt % DP2) (40 nm)
9.5: HTM2 (2 nm)
9.6: C₆₀:ZnPc (wt ratio 1:1; 30 nm)
9.7: C₆₀ (5 nm)
9.8: C₆₀:ND2 (20 wt % ND2) (5 nm)
9.9: (1a) (0-9 nm)
9.10: HTM1:DP2 (10 wt % DP2) (5 nm)
9.11: HTM1:DP2 (3 wt % DP2) (130 nm)
9.12: HTM1 (2 nm)
9.13: C₆ₒ:ZnPc (wt ratio 1:1; 30 nm)
9.14: C₆₀ (5 nm)
9.15: ET2:ND 1 (10 wt. % ND1) (40 nm)
9.16: Al (100 nm)

For comparison, an organic photoactive device (SC7) was prepared without the non-flat layer 9.9.

**Table 5 shows results determined for the two devices.**

| | | SC7 | SC8 |
|---|---|---|---|
| non-flat layer | | no | yes |
| Voc | V | 1.03 | 1.01 |
| Jsc | mA/cm² | 6.4 | 6.6 |
| FF | % | 54 | 52 |
| Sat. | | 1.07 | 1.08 |
| Effi. | % | 3.5 | 3.5 |

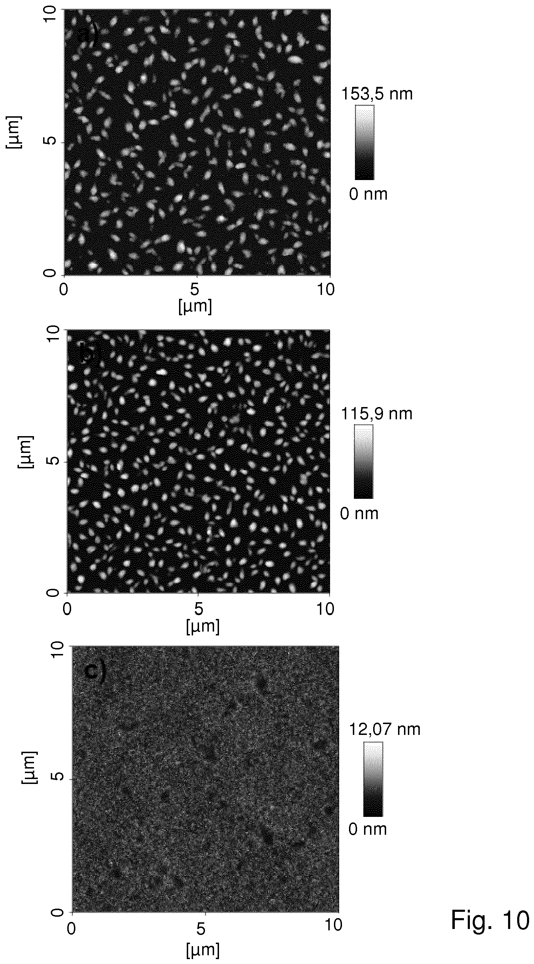

Fig. 10A to 10C show experimental results determined by atomic force microscopy. Fig. 10A and 10B show a top view of two organic photoactive devices comprising a non-flat layer. Fig. 10A corresponds to the stack of SC3 comprising a non-flat layer. Fig. 10B corresponds to the stack of SC6 comprising a non-flat layer.

The representation in Fig. 10C shows, for comparison, a device without a non-flat layer.

Fig. 10A shows that the OPVD comprising a non-flat layer has a structured top electrode as sketched in Fig. 4 and 5. Fig. 10C without a non-flat layer does not show any particles and can be considered as flat. Here the difference between the utilization of a non-flat layer can be seen.

Further examples of organic photoactive devices were prepared using the layer structure shown in Fig. 5. Again, devices with the non-flat layer (SC10, SC12) and without such layer (SC9, SC 11) were prepared. For providing the non-flat layer, the compounds (1d), (1e) were used.

Tables 6 and 7 show characteristics of the devices.

**Table 6**

| | | SC9 | SC10 |
|---|---|---|---|
| non-flat layer | | no | yes |
| Voc | V | 0.53 | 0.53 |
| Jsc | mA/cm² | 10.6 | 11.3 |
| FF | % | 56 | 56 |
| Sat. | | 1.14 | 1.16 |
| Effi. | % | 3.1 | 3.3 |

**Table 7**

| | | SC11 | SC12 |
|---|---|---|---|
| non-flat layer | | no | yes |
| Voc | V | 0.53 | 0.53 |
| Jsc | mA/cm² | 10.8 | 12.0 |
| FF | % | 56 | 56 |
| Sat. | | 1.15 | 1.15 |
| Effi. | % | 3.2 | 3.6 |

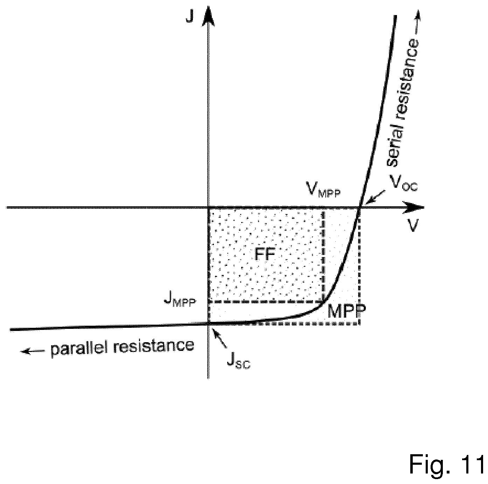

Fig. 11 shows a schematic representation for explaining characteristics of the organic photoactive device: J(V) - curve of a solar cell with the typical solar cell parameter open circuit voltage (V_{OC}), J_{SC} - photocurrent density at short circuit fill factor (FF), MPP - maximum power point, J_{MPP} - photocurrent density at MPP, and V_{MPP} - voltage at MPP. Further parameters which are determined for device characterization is the Saturation (Sat.) which is given by J(-1V)/Jsc and the Power Conversion Efficiency (Effi.) which is defined by V_{OC}^{∗}Jsc^{∗}FF/P. P is the irradiated power.

## Claims

1. An organic photovoltaic device, in a layered structure, comprising:
- a substrate (50),
- a bottom electrode (51),
- a top electrode (55), wherein the bottom electrode (51) is closer to the substrate (50) than the top electrode (55),
- an electronically active region (52, 53, 54), the electronically active region (52, 53, 54) being provided between and being in electrical contact with the bottom electrode (51) and the top electrode (55),
- a light absorbing region (53) provided in the electronically active region (52, 53, 54), and
- a non-flat layer (54) provided in the electronically active region (52, 53, 54),
wherein the non-flat layer (54) is a non-closed layer comprising a plurality of particles provided on an underlying layer and separated from each other by spaces free of such particles, **characterized in that** the non-flat layer (54) causes the top electrode (55) to be provided with an electrode roughness (57) by roughening the top electrode on an outer side of the top electrode (55) facing away from the electronically active region (52, 53, 54) such that the top electrode (55) is a non-flat electrode.

2. Device according to claim 1, wherein an electronically inactive non-flat layer is provided between the substrate (50) and the bottom electrode (51).

3. Device according to claim 1 or 2, wherein the non-flat layer (54) is an organic layer made of one or more organic materials.

4. Device according to one of the preceding claims, wherein the particles have a lateral dimension of 50 to 2000 nm.

5. Device according to at least one of the preceding claims as long as it refers to claim 2, wherein the bottom electrode (51) is a non-flat electrode, a non-flat surface structure of the non-flat electrode being caused by the non-flat structure of the electronically inactive non-flat layer.

6. Device according to at least one of the preceding claims, wherein the non-flat layer (54) is provided between the top electrode (55) and the light absorbing region (53).

7. Device according to at least one of the preceding claims, wherein the top electrode (55) comprises a metal layer.

8. Device according to at least one of the preceding claims, wherein the electronically active region (52, 53, 54) comprises an additional light absorbing region separated from the light absorbing region (53) by in intermediate region, the additional light absorbing region being provided between the non-flat layer (54) and the top electrode (55).

9. Device according to at least one of the preceding claims, wherein the height of the particles is bigger than a distance between a side of the top electrode (55) proximal to the electronically active region (52, 53, 54) and a first optical maximum.

10. Device according to at least one of the preceding claims, wherein the non-flat layer (54) is provided on an underlying layer comprising fullerene or a fullerene-comprising compound.

11. Device according to at least one of the preceding claims, wherein the non-flat layer (54) is provided with a nominal layer thickness of 3 nm to 50 nm.

12. Device according to at least one of the preceding claims, wherein the non-flat layer (54) comprises a compound according to the following formula (I): 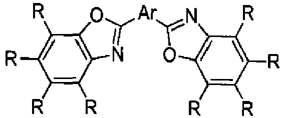 wherein Ar is C₆-C₂₀ aryl and each R is independently selected from H, C₁-C₂₀ alkyl, preferably C₁-C₁₀ alkyl, more preferably C₁-C₅ alkyl, C₆-C₂₀ aryl, preferably C₆-C₁₂ aryl, C₅-C₂₀ heteroaryl, preferably C₅-C₁₂ heteroaryl, halogen, nitro, CN and amine.

13. Method of producing a photovoltaic device provided with a layered structure, the method comprising steps of:
- providing a substrate (50),
- depositing a bottom electrode (51) on the substrate (50),
- forming an electronically active structure (52, 53, 54), the step of forming comprising the steps of:
- depositing a non-flat layer (54) on an underlying layer, and
- depositing an organic semiconducting layer on the non-flat layer, and
- depositing a top electrode (55) over the electronically active structure (52, 53, 54), wherein the non-flat layer (54) is formed as a non-closed layer comprising a plurality of particles provided on the underlying layer and separated from each other by spaces free of such particles, **characterized in that** the non-flat layer (54) causes the top electrode (55) to be provided with an electrode roughness (57) by roughening the top electrode (55) on an outer side of the top electrode (55) facing away from the electronically active region (52, 53, 54) such that the top electrode (55) is a non-flat electrode.

14. Method according to claim 13, wherein the non-flat layer (54) is deposited by vacuum thermal evaporation, and, during the vacuum deposition, controlling a nominal thickness of the non-flat layer by a quartz crystal monitor.

## Patentansprüche

1. Organische photovoltaische Vorrichtung, in einer Schichtstruktur, umfassend:
- ein Substrat (50),
- eine untere Elektrode (51),
- eine obere Elektrode (55), wobei die untere Elektrode (51) näher am Substrat (50) ist als die obere Elektrode (55),
- ein elektronisch aktiver Bereich (52, 53, 54), wobei der elektronisch aktive Bereich (52, 53, 54) zwischen der unteren Elektrode (51) und der oberen Elektrode (55) vorgesehen ist und in elektrischem Kontakt mit der unteren Elektrode (51) und der oberen Elektrode (55) ist,
- ein lichtabsorbierender Bereich (53), der im elektronisch aktiven Bereich (52, 53, 54) vorgesehen ist, und
- eine unebene Schicht (54), die im elektronisch aktiven Bereich (52, 53, 54) vorgesehen ist,
wobei die unebene Schicht (54) eine nicht geschlossene Schicht ist, die eine Vielzahl von Partikeln enthält, die auf einer darunterliegenden Schicht bereitgestellt werden und voneinander durch Räume getrennt sind, die frei von solchen Partikeln sind,
**dadurch gekennzeichnet, dass** die unebene Schicht (54) bewirkt, dass die obere Elektrode (55) durch Aufrauen der oberen Elektrode auf einer von dem elektronisch aktiven Bereich (52, 53, 54) wegweisenden Außenseite der oberen Elektrode (55) mit einer Elektrodenrauheit (57) versehen ist, sodass die obere Elektrode (55) eine unebene Elektrode ist.

2. Vorrichtung nach Anspruch 1, wobei eine elektronisch inaktive unebene Schicht zwischen dem Substrat (50) und der unteren Elektrode (51) vorgesehen ist.

3. Vorrichtung nach Anspruch 1 oder 2, wobei die unebene Schicht (54) eine organische Schicht ist, die aus einem oder mehreren organischen Materialien hergestellt ist.

4. Vorrichtung nach einem der vorherigen Ansprüche, wobei die Partikel eine laterale Abmessung von 50 bis 2000 nm haben.

5. Vorrichtung nach mindestens einem der vorherigen Ansprüche, sofern dieser sich auf Anspruch 2 bezieht, wobei die untere Elektrode (51) eine unebene Elektrode ist, wobei eine unebene Oberflächenstruktur der unebenen Elektrode durch die unebene Struktur der elektronisch inaktiven unebenen Schicht verursacht wird.

6. Vorrichtung nach mindestens einem der vorherigen Ansprüche, wobei die unebene Schicht (54) zwischen der oberen Elektrode (55) und dem lichtabsorbierenden Bereich (53) vorgesehen ist.

7. Vorrichtung nach mindestens einem der vorherigen Ansprüche, wobei die obere Elektrode (55) eine Metallschicht umfasst.

8. Vorrichtung nach mindestens einem der vorherigen Ansprüche, wobei der elektronisch aktive Bereich (52, 53, 54) einen zusätzlichen lichtabsorbierenden Bereich umfasst, der von dem lichtabsorbierenden Bereich (53) durch einen Zwischenbereich getrennt ist, wobei der zusätzliche lichtabsorbierende Bereich zwischen der unebenen Schicht (54) und der oberen Elektrode (55) vorgesehen ist.

9. Vorrichtung nach mindestens einem der vorherigen Ansprüche, wobei die Höhe der Partikel größer als ein Abstand zwischen einer Seite der oberen Elektrode (55) proximal zum elektronisch aktiven Bereich (52, 53, 54) und einem ersten optischen Maximum ist.

10. Vorrichtung nach mindestens einem der vorherigen Ansprüche, wobei die unebene Schicht (54) auf einer darunter liegenden Schicht vorgesehen ist, die Fulleren oder eine fullerenhaltige Verbindung umfasst.

11. Vorrichtung nach mindestens einem der vorherigen Ansprüche, wobei die unebene Schicht (54) mit einer Nennschichtdicke von 3 nm bis 50 nm versehen ist.

12. Vorrichtung nach mindestens einem der vorherigen Ansprüche, wobei die unebene Schicht (54) eine Verbindung nach der folgenden Formel (I) umfasst: 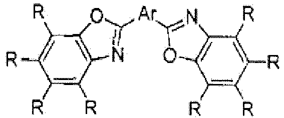 wobei Ar C₆-C₂₀-Aryl ist und jedes R unabhängig ausgewählt wird aus H, C₁-C₂₀-Alkyl, vorzugsweise C₁-C₁₀-Alkyl, weiter vorzugsweise C₁-C₅-Alkyl, C₆-C₂₀-Aryl, vorzugsweise C₆-C₁₂-Aryl, C₅-C₂₀-Heteroaryl, vorzugsweise C₅-C₁₂-Heteroaryl, Halogen, Nitro, CN und Amin.

13. Verfahren zum Erzeugen einer photovoltaischen Vorrichtung, die mit einer Schichtstruktur versehen ist, wobei das Verfahren die folgenden Schritte umfasst:
- Bereitstellen eines Substrats (50),
- Abscheiden einer unteren Elektrode (51) auf dem Substrat (50),
- Bilden einer elektronisch aktiven Struktur (52, 53, 54), wobei der Schritt des Bildens die folgenden Schritte umfasst:
- Abscheiden einer unebenen Schicht (54) auf einer darunterliegenden Schicht, und
- Abscheiden einer organischen halbleitenden Schicht auf der unebenen Schicht, und
- Abscheiden einer oberen Elektrode (55) über der elektronisch aktiven Struktur (52, 53, 54),
wobei die unebene Schicht (54) als eine nicht geschlossene Schicht gebildet wird, die eine Vielzahl von Partikeln umfasst, die auf der darunterliegenden Schicht bereitgestellt werden und voneinander durch Räume getrennt sind, die frei von solchen Partikeln sind,
**dadurch gekennzeichnet, dass** die unebene Schicht (54) bewirkt, dass die obere Elektrode (55) durch Aufrauen der oberen Elektrode auf einer von dem elektronisch aktiven Bereich (52, 53, 54) wegweisenden Außenseite der oberen Elektrode (55) mit einer Elektrodenrauheit (57) versehen ist, sodass die obere Elektrode (55) eine unebene Elektrode ist.

14. Verfahren nach Anspruch 13, wobei die unebene Schicht (54) durch thermische Vakuumverdampfung abgeschieden wird, und während der Vakuumabscheidung Steuern einer Nenndicke der unebenen Schicht durch einen Quarzkristallmonitor.

## Revendications

1. Dispositif photovoltaïque organique, selon une structure en couches, comprenant :
- un substrat (50),
- une électrode inférieure (51),
- une électrode supérieure (55), dans lequel l'électrode inférieure (51) est plus proche du substrat (50) que l'électrode supérieure (55),
- une région électroniquement active (52, 53, 54), la région électroniquement active (52, 53, 54) étant située entre et étant en contact électrique avec l'électrode inférieure (51) et l'électrode supérieure (55),
- une région absorbant la lumière (53) située dans la région électroniquement active (52, 53, 54), et
- une couche non plate (54) située dans la région électroniquement active (52, 53, 54),
dans lequel la couche non plate (54) est une couche non fermée comprenant une pluralité de particules situées sur une couche sous-jacente et séparées les unes des autres au moyen d'espaces exempts de telles particules,
**caractérisé en ce que** la couche non plate (54) amène l'électrode supérieure (55) à être munie d'une rugosité d'électrode (57) en rendant rugueuse l'électrode supérieure située sur un côté externe de l'électrode supérieure (55) située à l'opposé de la région électroniquement active (52, 53, 54) de sorte que l'électrode supérieure (55) est une électrode non plate.

2. Dispositif selon la revendication 1, dans lequel une couche non plate électroniquement inactive est située entre le substrat (50) et l'électrode inférieure (51).

3. Dispositif selon la revendication 1 ou 2, dans lequel la couche non plate (54) est une couche organique constituée d'un ou de plusieurs matériaux organiques.

4. Dispositif selon l'une quelconque des revendications précédentes, dans lequel les particules ont une dimension latérale de 50 à 2000 nm.

5. Dispositif selon l'une quelconque des revendications précédentes aussi longtemps qu'il se réfère à la revendication 2, dans lequel l'électrode inférieure (51) est une électrode non plate, une structure de surface non plate de l'électrode non plate étant causée par la structure non plate de la couche non plate électroniquement inactive.

6. Dispositif selon l'une quelconque des revendications précédentes, dans lequel la couche non plate (54) est située entre l'électrode supérieure (55) et la région absorbant la lumière (53).

7. Dispositif selon l'une quelconque des revendications précédentes, dans lequel l'électrode supérieure (55) comprend une couche métallique.

8. Dispositif selon l'une quelconque des revendications précédentes, dans lequel la région électroniquement active (52, 53, 54) comprend une région supplémentaire absorbant la lumière séparée de la région absorbant la lumière (53) au moyen d'une région intermédiaire, la région supplémentaire absorbant la lumière étant située entre la couche non plate (54) et l'électrode supérieure (55).

9. Dispositif selon l'une quelconque des revendications précédentes, dans lequel la hauteur des particules est supérieure à une distance entre un côté de l'électrode supérieure (55) étant proximale à la région électriquement active (52, 53, 54) et un premier maximum optique.

10. Dispositif selon l'une quelconque des revendications précédentes, dans lequel la couche non plate (54) est située sur une couche sous-jacente comprenant du fullerène ou un composé comprenant du fullerène.

11. Dispositif selon l'une quelconque des revendications précédentes, dans lequel la couche non plate (54) est munie d'une épaisseur de couche nominale de 3 nm à 50 nm.

12. Dispositif selon l'une quelconque des revendications précédentes, dans lequel la couche non plate (54) comprend un composé conformément à la formule (I) suivante : 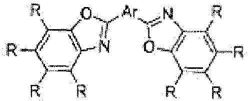 dans laquelle Ar représente un aryle en C₆-C₂₀ et chaque R est indépendamment choisi parmi H, alkyle en C₁-C₂₀, de préférence alkyle en C₁-C₁₀, plus préférablement alkyle en C₁-C₅, aryle en C₆-C₂₀, de préférence aryle en C₆-C₂₀, hétéroaryle en C₅-C₂₀, de préférence hétéroaryle en C₅-C₁₂, un halogène, un nitro, CN et une amine.

13. Procédé de production d'un dispositif photovoltaïque équipé d'une structure en couches, le procédé comprenant les étapes consistant à :
- obtenir un substrat (50),
- déposer une électrode inférieure (51) sur le substrat (50),
- former une structure électroniquement active (52, 53, 54), l'étape de formation comprenant les étapes consistants à :
- déposer une couche non plate (54) sur une couche sous-jacente, et
- déposer une couche semi-conductrice organique sur la couche non plate, et
- déposer une électrode supérieure (55) sur la structure électroniquement active (52, 53, 54),
dans lequel la couche non plate (54) est formée comme une couche non fermée comprenant une pluralité de particules situées sur la couche sous-jacente et séparées les unes des autres au moyen d'espaces exempts de telles particules,
**caractérisé en ce que** la couche non plate (54) amène l'électrode supérieure (55) à être munie d'une rugosité d'électrode (57) en rendant rugueuse l'électrode supérieure (55) située sur un côté externe de l'électrode supérieure (55) située à l'opposé de la région électroniquement active (52, 53, 54) de sorte que l'électrode supérieure (55) est une électrode non plate.

14. Procédé selon la revendication 13, dans lequel la couche non plate (54) est déposée par évaporation thermique sous vide, et, pendant le dépôt sous vide, commande d'une épaisseur normale de la couche non plate au moyen d'un moniteur à cristal de quartz.
